# EUROPÄISCHE PATENTSCHRIFT

(11) **EP 3 959 752 B1**
(45) Veröffentlichungstag und Bekanntmachung des Hinweises auf die Patenterteilung: **11.03.2026**
(21) Anmeldenummer: 20718618.0
(22) Anmeldetag: 07.04.2020
(51) Int. Cl.: H10N 30/88, H10N 30/50, H10N 30/053, H10N 30/02

(54) **ELEKTROMECHANISCHER AKTOR MIT KERAMISCHER ISOLIERUNG UND VERFAHREN ZU DESSEN HERSTELLUNG**
ELECTROMECHANICAL ACTUATOR HAVING CERAMIC INSULATION AND METHOD FOR PRODUCTION THEREOF
ACTIONNEUR ÉLECTROMÉCANIQUE À ISOLATION CÉRAMIQUE ET SON PROCÉDÉ DE FABRICATION

(30) Priorität: 26.04.2019 DE 102019206018
(43) Veröffentlichungstag der Anmeldung: 02.03.2022
(73) Patentinhaber: PI Ceramic GmbH, 07589 Lederhose (DE)
(72) Erfinder: SPEER, Kevin, 07646 Mörsdorf (DE); DARGATZ, Benjamin, 07745 Jena (DE)
(74) Vertreter: Grünecker Patent- und Rechtsanwälte PartG mbB
(86) Internationale Anmeldenummer: PCT/EP2020/059887
(87) Internationale Veröffentlichungsnummer: WO 2020/216612

(56) Entgegenhaltungen:
- EP-A1- 2 530 756
- EP-A2- 2 079 116
- DE-A1- 102011 081 279
- JP-A- 2006 303 349
- JP-A- 2015 142 027

## Beschreibung

Die vorliegende Erfindung betrifft einen elektromechanischen Aktor nach dem Oberbegriff des Anspruchs 1, umfassend eine Stapelanordnung aus keramischem Basismaterial mit elektromechanischen Eigenschaften und Elektroden sowie eine keramische Isolierung für den Einsatz des Aktors in feuchter Umgebung. Ein solcher Aktor wird auch als Vielschichtaktor oder Linear-Aktor bezeichnet. Ein weiterer Aspekt der Erfindung betrifft ein Verfahren zur Herstellung eines Aktors mit keramischer Isolierung.

Die Lebensdauer von elektromechanischen Aktoren wird unter anderem durch den Einsatz in statischen oder quasi-statischen Anwendungen durch den Degradationsmechanismus via Luftfeuchtigkeit begrenzt. Insbesondere verursacht ein Eindiffundieren oder Eindringen von Wasserdampfmolekülen in die Stapelanordnung einen teilweisen oder totalen Funktionsverlust des Aktors, da dies zu einer Verschlechterung des elektrischen und elastischen Verhaltens des Aktors führt. Eine erhöhte Lebensdauer kann durch eine Isolierung des Aktors, insbesondere mit oder aus einem keramischen Material, erreicht werden. Ein derartiger elektromechanischer bzw. piezoelektrischer Aktor mit keramischer Isolierung ist aus der DE 100 21 919 C2 bekannt. Im Vergleich zu Aktoren mit Polymer-Isolierung, können keramisch isolierte Aktoren bei Ansteuerung mit Gleichspannung (DC) eine um zwei bis drei Größenordnungen höhere mittlere Lebensdauer (Mean Time To Failure = MTTF) aufweisen.

Aus der EP 2 530 756 A1 ist ebenfalls ein piezoelektrischer Aktor bekannt, welcher an seinen Seitenflächen mit einer anorganischen Schicht, beispielsweise aus Blei-Zirkonat-Titanat (PZT), versehen ist. Auch die US 7,065,846 B2 offenbart einen piezokeramischen Aktor mit einer keramischen Isolierung.

Eine derartige keramische Isolierung weist allerdings physikalische Grenzen auf. Bisher zeigen keramisch beschichtete Aktoren typischerweise eine elektrisch induzierte piezoelektrische Dehnung von ca. 1,0 ‰ bis 1,1 ‰ der aktiven Länge des Aktors bei Ansteuerung mit einer elektrischen Feldstärke von 2 kV-DC/mm. Eine Erhöhung der elektrisch induzierten piezoelektrischen Dehnung auf beispielsweise > 1,25 ‰ der aktiven Länge, wie sie beispielsweise durch eine Optimierung des elektromechanischen Materialsystems Blei-Zirkonat-Titanat (PZT) möglich ist, führt zur unkontrollierten Entstehung und Wachstum von Rissen in der keramischen Isolierung, welche die Lebensdauer des Aktors nachtteilig beeinträchtigt. Durch das Design von Linear-Aktoren erstrecken sich die Elektroden nicht bis in die Isolierung hinein, da die Elektroden gerade vor Feuchtigkeit zu schützen sind. Folglich wird die keramische Isolierung ggf. nur von elektrischen Streufeldern angeregt, wodurch naturgemäß eine niedrigere, bis gar keine piezoelektrisch induzierte Dehnung der keramischen Isolierung erfolgt. Aus diesem Grund entsteht eine mechanische Zugspannung während der Ansteuerung bzw. Dehnung des Aktors, welche durch Dauer- bzw. Wechselbelastung zur Rissentstehung führt und einen Ausfall oder Funktionsverlust des Aktors nach sich ziehen kann bzw. dessen Lebensdauer in feuchter Umgebung herabsetzt. Die JP 2006-303349 A offenbart einen Vielschichtaktor aus piezoelektrischer Keramik und Innenelektroden mit einer keramischen Isolierung angebracht auf gegenüberliegenden Seitenflächen in Form von Streifen auf alternierend exponierten Enden der Innenelektroden, wobei die keramische Isolierung eine geringere mittlere Korngröße und eine andere Materialzusammensetzung als das keramische Basismaterial aufweisen kann.

Die WO 2017/032868 A1 offenbart einen piezoelektrischen Vielschichtaktor mit einer durch Luftstromabscheidung (vgl. S.4, Z. 14-16) auf der Aktoroberfläche erzeugten Schutzschicht aus aufgebrochenen und z.B. durch Tempern miteinander verbundenen Keramikpartikeln (vgl. S.4, Z. 28 - S.5, Z.2). Diese Schutzschicht soll sehr dicht und porenfrei sein und keine "Korngrenzen" enthalten, wie sie durch Sintervorgänge entstehen, sodass die Schutzschicht angeblich auch bei geringer Dicke beim Betrieb des Aktors rissfrei bleibt (vgl. S.5, Z.5-10). Die DE 102011 081279 A1 lehrt einen ähnlichen Piezo-Vielschichtaktor mit einer keramischen Isolierschicht, die sich etwa auf drei Seitenflächen über die gesamte Stapelhöhe erstreckt, hergestellt mittels Aerosol-Abscheidung von beispielsweise PZT. Die Isolierung ist aus dem selben Material gebildet wie die piezokeramischen Schichten.

Die EP 2 667 425 B1 offenbart ein piezoelektrisches Element mit einer anorganischen Beschichtung, in der Metallpartikel dispergiert sind. Aufgrund der Metallpartikel besteht die Gefahr leitfähiger Pfade in der Beschichtung, die sich insbesondere an Defekten ausbilden können, wodurch es zu einer Beschleunigung der Ausfallmechanismen kommen kann. Die JP 2015-142027 A beschreibt Stapelaktoren aus einem piezokeramischen Basismaterial mit keramischer Isolierung auf mindestens zwei gegenüberliegenden Seitenflächen, wobei die keramische Isolierung eine geringere mittlere Korngröße aufweist als das piezokeramische Basismaterial. Auch hier sind Isolierungs- und Basismaterial identisch (z.B. PZT) aber die Isolierung reicht nicht bis an die Stirnflächen des Stapels.

Der vorliegenden Erfindung liegt die Aufgabe zugrunde, einen elektromechanischen Aktor bereitzustellen, der auch bei einer Erhöhung der elektromechanischen Dehnung eine verlängerte Lebensdauer aufweist, indem die Entstehung von Rissen in einer gesinterten keramischen Isolierung verhindert wird.

Die Aufgabe der Erfindung wird durch den elektromechanischen Aktor gemäß Anspruch 1 sowie ein Verfahren zur Herstellung eines elektromechanischen Aktors gemäß Anspruch 9 gelöst. Vorteilhafte Weiterentwicklungen der Erfindung werden in den Unteransprüchen beansprucht.

Der erfindungsgemäße elektromechanische Aktor umfasst eine Stapelanordnung aus keramischem Basismaterial mit elektromechanischen Eigenschaften und Elektroden sowie eine keramische Isolierung für den Einsatz des Aktors in feuchter Umgebung, wobei das Gefüge der keramischen Isolierung eine geringere mittlere Korngröße aufweist als das Gefüge des keramischen Basismaterials. Durch die spezifische Auswahl einer keramischen Isolierung, deren Gefüge eine geringere mittlere Korngröße aufweist als das Gefüge des keramischen Basismaterials wird die Festigkeit (Streckgrenze, siehe Hall-Petch-Beziehung) der keramischen Isolierung und deren Widerstandsfähigkeit gegen eine Rissentstehung erhöht. Durch Erhöhung dieser Widerstandsfähigkeit kann eine verlängerte Lebensdauer des Aktors auch bei einer höheren elektromechanischen Dehnung erreicht werden, welche sich aufgrund der größeren mittleren Korngröße im Gefüge des keramischen Basismaterials erzielen lässt, da die nutzbare elektrisch induzierte Dehnung des Materials mit wachsender Korngröße ansteigt. Vorzugsweise ist das keramische Basismaterial ein piezokeramisches Basismaterial. Die elektromechanischen Eigenschaften des Aktors werden vorzugsweise nach der Formgebung des keramischen Basismaterials z. B. durch Polarisation verändert bzw. eingestellt.

Es kann von Vorteil sein, wenn das Verhältnis der mittleren Korngrößen von Isolierung zu keramischem Basismaterial 3/4 oder weniger, vorzugsweise 1/2 oder weniger, besonders bevorzugt 1/3 oder weniger, beträgt. Je kleiner die mittlere Korngröße der Isolierung ist, umso höher ist grundsätzlich die Festigkeit und Widerstandsfähigkeit der Isolierung gegenüber Risswachstum. Die genannten Verhältnisse erzielen vorteilhafte Ergebnisse unter Berücksichtigung der mechanischen Wechselwirkungen zwischen Basismaterial und Isolierung.

Weiter kann es sinnvoll sein, wenn die mittlere Korngröße der Isolierung 20 µm oder weniger, vorzugsweise 5 µm oder weniger, besonders bevorzugt 1 µm oder weniger, beträgt.

Außerdem kann es sich als praktisch erweisen, wenn die mittlere Korngröße des keramischen Basismaterials zur Isolierung hin, vorzugsweise über die Isolierung hinweg, bevorzugt kontinuierlich, abnimmt. Durch eine kontinuierliche Abnahme der mittleren Korngröße in dem Bereich, in dem die Isolierung an das keramische Basismaterial angrenzt, kann ein Dehnungs- bzw. Spannungssprung in diesem Bereich vermieden werden.

Es kann sich als nützlich erweisen, wenn die Isolierung aus einem elektromechanischen, bevorzugt piezoelektrischen und besonders bevorzugt piezokeramischen Material besteht.

Zudem kann es vorteilhaft sein, wenn die Isolierung undurchlässig/impermeabel für Wasserdampf/Feuchtigkeit ist. Dadurch wird ein Eindiffundieren oder Eindringen von Wasserdampfmolekülen in die Stapelanordnung verhindert.

Es kann von Nutzen sein, wenn die Isolierung mindestens aus einer Schicht, vorzugsweise aus zwei oder drei Schichten besteht, wobei die Gesamtdicke der Isolierung 500 µm oder weniger, vorzugsweise 100 µm oder weniger, besonders bevorzugt 60 µm oder weniger, beträgt. Durch die Bereitstellung mehrerer Schichten können fertigungstechnische Defekte, wie z.B. Löcher oder Poren, in einer einzelnen Schicht von den weiteren Schichten überdeckt werden, was zu einer Verbesserung der Isolierung führt. Die Wahrscheinlichkeit durchgehender Defekte durch die gesamte Dicke der Isolierung wird damit durch jede zusätzliche Schicht reduziert.

Erfindungsgemäß weist die Isolierung eine andere Materialzusammensetzung auf als das keramische Basismaterial.

Zudem kann es nützlich sein, wenn zwei Außenelektroden zur Kontaktierung der Elektroden in der Stapelanordnung vorgesehen sind, die an der gleichen Außenfläche oder an zwei unterschiedlichen Außenflächen des Aktors angeordnet sind, wobei mindestens eine elektrodenfreie Außenfläche des Aktors die keramische Isolierung aufweist. Durch das Anbringen der Außenelektroden und die Bereitstellung der keramischen Isolierung auf den elektrodenfreien Außenflächen kann der Aktor zuverlässig isoliert werden.

Erfindungsgemäß sind das keramische Basismaterial und die Elektroden entlang einer Stapelachse angeordnet, wobei die Stapelanordnung zwei senkrecht zur Stapelachse ausgerichtete Stirnseiten und mindestens eine sich zwischen den Stirnseiten erstreckende Seitenfläche aufweist und wobei sich die keramische Isolierung auf der mindestens einen Seitenfläche von einer Stirnfläche zur anderen Stirnfläche erstreckt. Die Bereitstellung der keramischen Isolierung an diesen Seitenflächen verhindert das Eindiffundieren oder Eindringen von Wasserdampfmolekülen zwischen die Elektroden und das keramische Basismaterial.

Ein weiterer Aspekt der Erfindung betrifft ein Verfahren zur Herstellung eines elektromechanischen Aktors, insbesondere eines Aktors nach einer der vorangehenden Ausführungen, umfassend die Schritte:
A: Bilden einer Stapelanordnung aus Elektroden und aus keramischem Basismaterial mit elektromechanischen Eigenschaften entlang einer Stapelachse, sodass die Stapelanordnung zwei senkrecht zur Stapelachse ausgerichtete Stirnseiten und mindestens eine sich zwischen den Stirnseiten erstreckende Seitenfläche aufweist,
B: Versehen der Stapelanordnung mit einer keramischen Isolierung, sodass diese sich auf der mindestens einen Seitenfläche von einer Stirnfläche zur anderen Stirnfläche erstreckt, das Gefüge der Isolierung eine geringere mittlere Korngröße aufweist als das Gefüge des keramischen Basismaterials und die Isolierung eine andere Materialzusammensetzung aufweist als das keramische Basismaterial.

Weiterhin kann es nützlich sein, wenn das Verfahren wenigstens einen der folgenden Teilschritte umfasst:
A1: Bilden der Stapelanordnung aus den Elektroden und aus Grünfolien aus dem keramischen Basismaterial,
A2: Sintern der Stapelanordnung, sodass das keramische Basismaterial in ein festes keramisches Gefüge überführt wird.

Es kann aber auch vorteilhaft sein, wenn das Verfahren wenigstens einen der folgenden Teilschritte umfasst:
B1: Aufbringen wenigstens einer der, mehrerer oder aller Schichten der Isolierung auf die Stapelanordnung durch Beschichten, vorzugsweise mit einer Grünfolie, Spritzgießen, Plasmaspritzen, Tauchumhüllung, vorzugsweise in keramischem Schlicker, Besprühen und/oder im Sol-Gel-Verfahren,
B2: Sintern der keramischen Isolierung und gegebenenfalls des keramischen Basismaterials, sodass die keramische Isolierung und gegebenenfalls das keramische Basismaterial in ein festes keramisches Gefüge überführt wird/werden,
B3: Einstellen der mittleren Korngröße der Isolierung und gegebenenfalls der mittleren Korngröße des keramischen Basismaterials durch unterschiedliche Materialwahl für das keramische Basismaterial und die keramische Isolierung und/oder durch Wahl der Prozessparameter während des Sinterns.

Außerdem kann es von Vorteil sein, wenn das Verfahren den folgenden Schritt umfasst:
C: Polarisieren des keramischen Basismaterials, und vorzugsweise der keramischen Isolierung, zur Einstellung der elektromechanischen Eigenschaften des Aktors.
Wie oben bereits erwähnt, verhindert die Bereitstellung der keramischen Isolierung an diesen Seitenflächen das Eindiffundieren oder Eindringen von Wasserdampfmolekülen zwischen die Elektroden und das keramische Basismaterial.

Offenbart wird auch ein Verfahren zur Ansteuerung eines elektromechanischen Aktors, insbesondere eines Aktors nach einer der vorangegangen Ausführungen, mit einer elektrischen Feldstärke von wenigstens 2kV-DC/mm, bei Raumtemperatur und bevorzugt bei wenigstens 80 %, vorzugsweise wenigstens 85 %, bevorzugt wenigstens 90 % und besonders bevorzugt wenigstens 92 % Luftfeuchtigkeit, sodass eine quasistatische Dehnung von 1,25 ‰ oder mehr der aktiven Länge des Aktors und eine mittlere Lebensdauer (MTTF) des Aktors von 10.000 Stunden oder mehr erreicht wird.

Offenbart wird zusätzlich ein Verfahren zur Ansteuerung eines elektromechanischen Aktors, insbesondere eines Aktors nach einer der vorangegangenen Ausführungen, mit einer elektrischen Feldstärke von wenigstens 2kV-DC/mm, bei 90 °C und bevorzugt bei wenigstens 80 %, vorzugsweise wenigstens 85 %, bevorzugt wenigstens 90 % und besonders bevorzugt wenigstens 92 % Luftfeuchtigkeit, sodass eine quasistatische Dehnung von 1,25 ‰ oder mehr der aktiven Länge des Aktors und eine mittlere Lebensdauer (MTTF) des Aktors von 500 Stunden oder mehr erreicht wird.

### Begriffe und Definitionen

### Grünfolie aus keramischem Material

Als Grünfolie aus keramischem Material wird eine flexible Folie bezeichnet, welche durch einen Foliengießprozess aus keramischem Schlicker hergestellt wird.

### Isolierung

Als Isolierung wird eine Schutzschicht bezeichnet, die das Eindringen von Feuchtigkeit in den Stapelaktor verhindert.

### Aktor

Der Begriff Aktor wird synonym für einen Stapelaktor, Vielschichtaktor, Mehrschichtaktor oder Linearaktor verwendet.

### Keramisches Basismaterial mit elektromechanischen Eigenschaften

Als keramisches Basismaterial mit elektromechanischen Eigenschaften wird ein Material bezeichnet, dass bei Anlegen einer elektrischen Spannung eine mechanische (elastische) Deformation erzeugt. Ausgangspunkt dieses Materials kann ein keramisches Pulver sein, welches zur Formgebung gesintert wird. Die gesinterte Keramik ist in ihrer Mikrostruktur ein polykristalliner Werkstoff, dessen Kristallite Domänen mit Dipolen aufweisen, deren Ausrichtung im gesamten Werkstoff statistisch verteilt ist. Zur Einstellung der elektromechanischen Eigenschaften des Aktors werden die Dipole gleichgerichtet, vorzugsweise durch Polarisation.

### Polarisation

Für die Herstellung der meisten elektromechanischen Aktoren wird das Material nach dem Sintern durch Anlegen eines äußeren Gleichfeldes polarisiert, das heißt, die Dipole werden insgesamt gleichgerichtet. Die Polarisation ermöglicht damit die Einstellung der gewünschten elektromechanischen Eigenschaften des Aktors.

### Kurze Beschreibung der Figuren

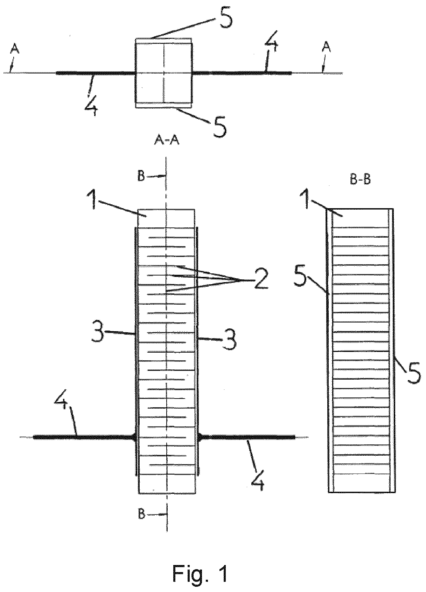

Figur 1 zeigt eine Draufsicht des erfindungsgemäßen Aktors sowie Schnitte längs der Linien A-A und B-B.

### Detaillierte Beschreibung der bevorzugten Ausführungsbeispiele

Figur 1 zeigt einen elektromechanischen Aktor, bestehend aus einer stabförmigen Stapelanordnung 1 aus keramischem Basismaterial mit elektromechanischen Eigenschaften und Elektroden 2, welche alternierend an gegenüberliegende Seitenflächen des Aktors geführt sind. Auf jeder dieser beiden Seitenflächen ist eine Außenelektrode 3 zur Kontaktierung der Elektroden 2 aufgebracht. Die Außenelektroden 3 sind jeweils mit einem Anschlussleiter 4 verbunden. Die Seitenflächen des Aktors, die nicht von den Außenelektroden abgedeckt werden, sind mit einer keramischen Isolierung 5 versehen.

Der grundsätzliche Aufbau dieser Stapelanordnung ist aus der DE 100 21 919 C2 bekannt und wird an dieser Stelle nicht näher erläutert. Stattdessen wird vorwiegend auf die erfindungsgemäßen Unterschiede zu der bekannten Stapelanordnung eingegangen, die nachstehend erläutert werden.

Erfindungsgemäß weist das Gefüge der keramischen Isolierung 5 eine geringere mittlere Korngröße auf als das Gefüge des keramischen Basismaterials. Aufgrund der geringen mittleren Korngröße stellt sich im Gefüge der keramischen Isolierung 5 eine geringe Porengröße bzw. Porosität ein, wodurch die Defektgröße im Gefüge sinkt und einer Entstehung oder einem Wachstum von Rissen entgegenwirkt.

Erfindungsgemäß sind das keramische Basismaterial und die Elektroden entlang einer Stapelachse angeordnet, wobei die Stapelanordnung aus keramischem Basismaterial und Elektroden zwei senkrecht zur Stapelachse ausgerichtete Stirnseiten und mindestens eine sich zwischen den Stirnseiten erstreckende Seitenfläche aufweist und sich die keramische Isolierung auf der mindestens einen Seitenfläche von einer Stirnfläche zur anderen Stirnfläche erstreckt. Ohne die keramische Isolierung wären die Elektroden an den umfangsseitigen Seitenflächen exponiert. Die Bereitstellung der keramischen Isolierung an diesen Seitenflächen verhindert daher das Eindiffundieren oder Eindringen von Wasserdampfmolekülen zwischen die Elektroden und das keramische Basismaterial.

In bevorzugter Ausführungsform beträgt das Verhältnis der mittleren Korngrößen von Isolierung zu keramischem Basismaterial 3/4 oder weniger, vorzugsweise 1/2 oder weniger, besonders bevorzugt 1/3 oder weniger. Dabei kann die mittlere Korngröße der Isolierung 20 µm oder weniger, vorzugsweise 5 µm oder weniger, besonders bevorzugt 1 µm oder weniger, betragen.

Bei dem keramischen Basismaterial handelt es sich vorzugsweise um ein piezokeramisches Material, wie z. B. Blei-Zirkonat-Titanat (PZT). Daneben kann es sich jedoch auch um ein elektrostriktives oder magnetostriktives Material handeln. Die keramische Isolierung 5 besteht aus einem anderen Material als das keramische Basismaterial, insbesondere aus einer Oxidkeramik und weist bevorzugt ebenfalls piezoelektrische Eigenschaften auf.

Die keramische Isolierung 5 kann aus einer einzelnen Schicht bestehen. In bevorzugter Ausführung weist die keramische Isolierung 5 jedoch mehrere Schichten auf, insbesondere zwei oder drei, um fertigungstechnisch bedingte Defekte in einer Einzelschicht durch eine andere Schicht zu überdecken. Dadurch kann das Risswachstum an der Grenze zwischen zwei Isolierungsschichten unterbunden werden. Folglich kann die keramische Isolierung 5 zuverlässig impermeabel gegenüber einem Eindringen oder Eindiffundieren von Wasserdampfmolekülen in die Stapelanordnung gemacht werden. Die Einzelschichten können sich in ihrer Zusammensetzung oder in ihrer mittleren Korngröße voneinander unterscheiden. Die Dicke einer Einzelschicht beträgt dabei ein Vielfaches, vorzugsweise das Fünf- bis Zwanzigfache der mittleren Korngröße in dieser Schicht. Im Allgemeinen ist eine geringe Gesamtdicke der keramischen Isolierung anzustreben, da die Dehnung des keramischen Basismaterials durch eine dünne Isolierung weniger eingeschränkt wird. In bevorzugter Ausführungsform beträgt die Gesamtdicke der Isolierung 500 µm oder weniger, vorzugsweise 100 µm oder weniger, besonders bevorzugt 60 µm oder weniger.

Im Folgenden wird ein erfindungsgemäßes Verfahren zur Herstellung eines Aktors, vorzugsweise eines Aktors nach den obigen Ausführungsformen, beschrieben.

Die Herstellung einer Stapelanordnung aus keramischem Basismaterial mit elektromechanischen Eigenschaften und Elektroden ist grundsätzlich aus der DE 100 21 919 C2 bekannt, wird jedoch zur Verbesserung des Verständnisses des erfindungsgemäßen Verfahrens nochmal kurz umrissen.

Den Ausgangspunkt zur Herstellung der Stapelanordnung 1 bildet ein keramischer Pulverwerkstoff, vorzugsweise ein PZT-Pulverwerkstoff, welcher mit einer Binderlösung und einem Lösungsmittel versehen wird. Im weiteren Verfahrensverlauf wird der keramische Schlicker aus Pulverwerkstoff und Binderlösung zu sogenannten Grünfolien aus keramischem Basismaterial gegossen und das Lösungsmittel verflüchtigt sich. Die flexiblen Grünfolien werden anschließend zugeschnitten und gestapelt, wobei zwischen jeweils zwei Schichten aus einer vordefinierten Anzahl von Grünfolien eine Elektrode 2 eingebracht wird. Dazu wird eine Metallpaste im Siebdruckverfahren auf die entsprechende Grünfolie aufgedruckt. Die so erzeugte Stapelanordnung 1 wird anschließend isostatisch verpresst.

Das erfindungsgemäße Verfahren sieht nun vor, eine derartige Stapelanordnung 1 mit einer keramischen Isolierung 5 zu versehen, sodass das Gefüge der keramischen Isolierung 5 eine geringere mittlere Korngröße aufweist als das Gefüge des keramischen Basismaterials. Dazu wird/werden in bevorzugter Ausführungsform eine oder mehrere Grünfolien mit einer anderen Materialzusammensetzung oder mit anderen Materialeigenschaften als die Grünfolien des keramischen Basismaterials auf wenigstens eine Seitenfläche der Stapelanordnung 1 aufgebracht. Anschließend erfolgt ein gemeinsames Sintern der Stapelanordnung 1 und der keramischen Isolierung 5, wodurch die Grünfolien des keramischen Basismaterials und der keramischen Isolierung 5 in ein festes keramisches Gefüge überführt werden. Durch die gezielte Einstellung der Zusammensetzungen und/oder der Eigenschaften der Ausgangsmaterialien des keramischen Basismaterials und der keramischen Isolierung 5 kann im festen Gefüge der keramischen Isolierung 5 eine geringere mittlere Korngröße erreicht werden als im Gefüge des keramischen Basismaterials. Nach dem Sintern erfolgt das Aufbringen von Außenelektroden 3 auf die Seitenflächen des Aktors, die für die elektrische Kontaktierung der Elektroden 2 in der Stapelanordnung 1 ausgebildet sind und keine keramische Isolierung 5 aufweisen. Nach dem Aufbringen der Außenelektroden wird zum Erzeugen einer Polarisation ein elektrisches Gleichfeld angelegt um das keramische Basismaterial, und vorzugsweise die keramische Isolierung 5, zu polarisieren. Bei dem oben beschriebenen Verfahren handelt es sich um ein einstufiges Verfahren, da die Stapelanordnung 1 und die keramische Isolierung 5 gemeinsam gesintert werden. Daneben ist es auch möglich, ein zweistufiges Verfahren durchzuführen, in dem zunächst die Stapelanordnung 1 gesintert wird, anschließend eine oder mehrere Schichten der keramischen Isolierung 5 auf die gesinterte Stapelanordnung 1 aufgebracht wird/werden und im Folgenden die mit der keramischen Isolierung 5 versehene Stapelanordnung nochmals gesintert wird. Die Einstellung der verschiedenen mittleren Korngrößen im Gefüge der keramischen Isolierung 5 und des keramischen Basismaterials kann hierbei insbesondere durch die gezielte Wahl der Prozessparameter in den einzelnen Sinterstufen erzielt werden.

Gemäß den obigen Ausführungsformen wird die Einstellung der mittleren Korngrößen in den entsprechenden Gefügen im einstufigen Verfahren im Wesentlichen über die unterschiedlichen Zusammensetzungen bzw. Eigenschaften der Ausgangsmaterialien des keramischen Basismaterials und der keramischen Isolierung 5 erreicht, im zweistufigen Verfahren hingegen im Wesentlichen über die Wahl der Prozessparameter in den einzelnen Sinterprozessen. Das erfindungsgemäße Verfahren ist jedoch nicht auf ein derartiges ein- oder mehrstufiges Verfahren beschränkt.

Daneben kann auch im einstufigen Verfahren durch geeignete Wahl der Prozessparameter die gewünschte Einstellung der mittleren Korngröße in den entsprechenden Gefügen erreicht werden. Beim Mikrowellensintern, das nachfolgend genauer beschrieben ist, ergibt sich in der Stapelanordnung eine ungleichmäßige Wärmeverteilung, bei der in den Randbereichen der Isolierung aufgrund der über die Oberfläche der Stapelanordnung abgestrahlten Energie geringere Temperaturen vorliegen, sodass das Kornwachstum in der Mitte größer ist als in der Isolierung.

Eine ungleichmäßige Temperaturverteilung in der Stapelanordnung während des Sinterprozesses ist auch durch Beaufschlagung der Aktoren mit einer geeigneten elektrischen Spannung möglich, da der resultierende Stromfluss für eine Erwärmung sorgt, und wegen der Energieabstrahlung an der Oberfläche der Stapelanordnung diese eine geringere Temperatur aufweist als dessen Kernbereich. Das aus der elektrischen Spannung resultierende elektrische Feld im Innern der Stapelanordnung kann zusätzlich einen positiven Einfluss auf das Kornwachstum bzw. die Korngrößenverteilung in dem Stapel und der Isolierung haben.

Darüber hinaus kann das Kornwachstum auch durch ein äußeres elektrisches Feld, ohne dass ein leitfähiger Kontakt zu den Aktoren besteht, in dem oben genannten Sinne (gradueller Verlauf der Korngröße in der keramischen Isolation) beeinflusst werden.

Weiterhin können im zweistufigen Verfahren auch unterschiedliche Materialzusammensetzungen bzw. Materialeigenschaften zusätzlich zu verschiedenen Prozessparametern in den einzelnen Sinterprozessen zum Einsatz kommen.

Im Folgenden werden einige Beispiele zur Realisierung von unterschiedlichen Zusammensetzungen bzw. Eigenschaften der Ausgangsmaterialien erläutert, die zu der Einstellung von unterschiedlichen mittleren Korngrößen in den entsprechenden Gefügen beitragen können.

Zum einen empfiehlt es sich für das keramische Basismaterial ein Ausgangsmaterial einzusetzen, dessen mittlere Korngröße bei typischer Sinterung ausreichend groß ist, um Dehnungen > 1,1 ‰ zu erreichen. Für die keramische Isolierung 5 kann dieses Material mit einem Kornwachstumshemmer dotiert werden, um in einem anschließenden Sinterprozess das Kornwachstum im Gefüge der keramischen Isolierung 5 gegenüber dem Kornwachstum im Gefüge des keramischen Basismaterials zu hemmen.

Zum anderen kann für die keramische Isolierung 5 ein Ausgangsmaterial eingesetzt werden, dessen mittlere Korngröße bei typischer Sinterung ausreichend klein ist, um den Festigkeitsanforderungen der Isolierung zu genügen. Für das keramische Basismaterial kann dieses Material mit einem Kornwachstumsbeschleuniger dotiert werden, um in einem anschließenden Sinterprozess das Kornwachstum im Gefüge des keramischen Basismaterials gegenüber dem Kornwachstum im Gefüge der keramischen Isolierung 5 zu beschleunigen.

Weiterhin können sich die Ausgangsmaterialien des keramischen Basismaterials und der keramischen Isolierung 5 in ihrer initialen Korngröße unterscheiden. Das heißt, für die keramische Isolierung 5 kann gegenüber dem keramischen Basismaterial ein besonders fein gemahlenes Pulver verwendet werden, was auch nach dem Sintern zu einer geringeren mittleren Korngröße im Gefüge der keramischen Isolierung 5 führt.

Daneben besteht insbesondere für den Fall von PZT-Werkstoffen die Möglichkeit, für das keramische Basismaterial und die keramische Isolierung 5 Ausgangsmaterialien zu wählen, sie sich in ihrer Affinität zu Blei unterscheiden. Wird für das keramische Basismaterial ein Ausgangsmaterial mit höherer Affinität zu Blei als das Ausgangsmaterial für die keramische Isolierung 5 gewählt, entzieht das keramische Basismaterial der keramischen Isolierung einen Teil des enthaltenen Bleis. Durch diesen Entzug wird die Kornwachstumsdynamik in der keramischen Isolierung 5 gebremst.

Um den gewünschten Unterschied der mittleren Korngrößen in den entsprechenden Gefügen einzustellen, können die oben genannten Möglichkeiten zur Realisierung von verschiedenen Materialzusammensetzungen bzw. Materialeigenschaften alleine oder in Kombination angewendet werden.

Für die jeweiligen Sinterprozesse beschreiben im Wesentlichen die Temperatur bzw. der Temperaturverlauf über die Zeit, die Haltezeit, elektrische Felder in der Umgebung und die Umgebungsatmosphäre, insbesondere der Sauerstoffgehalt und der atmosphärische Druck, die einstellbaren Prozessparameter, welche alleine oder in Kombination dazu beitragen können unterschiedliche mittlere Korngrößen in den entsprechenden Gefügen zu realisieren.

Darüber hinaus kann der Unterschied der mittleren Korngröße in den entsprechenden Gefügen auch über den Einsatz von Mikrowellensintern erreicht werden. Aufgrund der Dipolstruktur von Piezokeramiken entsteht die Wärme beim Mikrowellensintern im Volumen des Bauteils. Da von der Oberfläche des Bauteils Wärme an die kältere Umgebung, d. h. die Atmosphäre und Wände der Sinteranlage abgegeben wird, liegt die Sintertemperatur der Oberfläche und damit der keramischen Isolierung 5 unter der Kerntemperatur des keramischen Basismaterials. Als Folge dieses Temperaturunterschieds verläuft das Kornwachstum in der keramischen Isolierung 5 langsamer.

Das vorliegende Verfahren ist nicht auf den Schichtauftrag der keramischen Isolierung 5 in Form einer Grünfolie beschränkt. Daneben bestehen die Möglichkeiten, das Ausgangsmaterial der keramischen Isolierung 5 durch Spritzguss, Plasmaspritzen, Tauchumhüllung in keramischem Schlicker, Sprühen oder im Sol-Gel-Verfahren aufzubringen. Mit Ausnahme des Plasmaspritzens können alle genannten Methoden des Schichtauftrags sowohl für ein einstufiges als auch für ein zweistufigen Sinterverfahren, wie oben beschrieben, angewendet werden. Plasmagespritzte Schichten müssen nicht erneut gesintert werden, sondern können nach dem Schichtauftrag bereits ihre gewünschten Eigenschaften aufweisen. Eine nachträgliche Temperaturbehandlung kann jedoch vorteilhaft sein.

Jede der oben genannten Methoden des Schichtauftrags lässt sich mit den bereits genannten Möglichkeiten der unterschiedlichen Materialzusammensetzungen bzw. Materialeigenschaften und der Prozessparameter während des Sinterns kombinieren. Weiterhin lassen sich bei allen genannten Methoden eine oder mehrere Schichten der keramischen Isolierung 5 realisieren.

Durch die Wahl von unterschiedlichen Materialzusammensetzungen bzw. Materialeigenschaften in jeder Schicht der keramischen Isolierung 5 oder durch einzelnes Sintern jeder dieser Schichten lässt sich ein Korngrößengradient über die keramische Isolierung 5 einstellen. Weiterhin kommt es auch durch Interaktion, insbesondere Diffusion, an den Schichtgrenzen von Schichten mit unterschiedlicher Materialzusammensetzung bzw. Materialeigenschaften zu einem Korngrößengradienten an diesen Schichtgrenzen. Durch einen derartigen Korngrößengradienten lassen sich Dehnungs-bzw. Spannungssprünge vermeiden.

Erfindungsgemäße, bereits polarisierte Aktoren wurden einem statischen Lebensdauertest mit konstanter Spannung (DC) unterzogen. Parallel wurden Aktoren mit keramischer Isolierung nach dem Stand der Technik untersucht. Die Ansteuerspannung wurde so gewählt, dass die Aktoren eine Dehnung der aktiven Region von 1,47 ‰ aufwiesen. Anhand der Ausfallzeitpunkte der Aktoren je Versuchsgruppe wurde die mittlere Lebensdauer MTTF der Aktoren ermittelt. Die ermittelten Werte sowie die Testbedingungen sind Tabelle 1 zu entnehmen.

Die MTTF für polymerumhüllte Aktoren wurde rechnerisch mit Hilfe der Lebensdauerformel des entsprechenden Herstellers berechnet.

Die MTTF der erfindungsgemäßen Aktoren bei 25°C und 30% relativer Feuchte wurde basierend auf einer Versuchsreihe durch Extrapolation ermittelt.

**Tabelle 1**

| **Aktortyp** | **Testbedingungen** | **Mittlere Lebensdauer MTTF** |
|---|---|---|
| Polymerumhüllte Vielschichtaktoren | 1,47‰ Dehnung, 80°C, 80% relative Feuchte, DC | 44 h |
| Keramisch isolierte Vielschichtaktoren mit gleicher mittlerer Korngröße in der Isolierung wie im Basismaterial | 1,47‰ Dehnung, 80°C, 80% relative Feuchte, DC | 1360 h |
| Keramisch isolierte Vielschichtaktoren mit geringerer mittlerer Korngröße in der Isolierung als im Basismaterial (erfindungsgemäß) | 1,47‰ Dehnung, 80°C, 80% relative Feuchte, DC | 2460 h |
| Keramisch isolierte Vielschichtaktoren mit geringerer mittlerer Korngröße in der Isolierung als im Basismaterial (erfindungsgemäß) | 1,47‰ Dehnung, 25°C, 30% relative Feuchte, DC | > 500000 h |

### Bezugszeichenliste

- 1: Stapelanordnung
- 2: Elektroden
- 3: Außenelektroden
- 4: Anschlussleiter
- 5: keramische Isolierung

## Patentansprüche

1. Elektromechanischer Aktor, umfassend eine Stapelanordnung (1) aus keramischem Basismaterial mit elektromechanischen Eigenschaften und Elektroden (2), die entlang einer Stapelachse angeordnet sind, sowie eine keramische Isolierung (5) für den Einsatz des Aktors in feuchter Umgebung, wobei die Stapelanordnung (1) zwei senkrecht zur Stapelachse ausgerichtete Stirnseiten und mindestens eine sich zwischen den Stirnseiten erstreckende Seitenfläche aufweist, wobei sich die keramische Isolierung (5) auf der mindestens einen Seitenfläche von einer Stirnfläche zur anderen Stirnfläche erstreckt, wobei das Gefüge der keramischen Isolierung (5) eine geringere mittlere Korngröße aufweist als das Gefüge des keramischen Basismaterials und wobei die Isolierung (5) eine andere Materialzusammensetzung aufweist als das keramische Basismaterial.

2. Aktor nach Anspruch 1, wobei das Verhältnis der mittleren Korngrößen von Isolierung (5) zu keramischem Basismaterial 3/4 oder weniger, vorzugsweise 1/2 oder weniger, besonders bevorzugt 1/3 oder weniger, beträgt.

3. Aktor nach einem der vorangehenden Ansprüche, wobei die mittlere Komgröße der Isolierung 20 µm oder weniger, vorzugsweise 5 µm oder weniger, besonders bevorzugt 1 µm oder weniger, beträgt.

4. Aktor nach einem der vorangehenden Ansprüche, wobei die mittlere Korngröße des keramischen Basismaterials zur Isolierung (5) hin, vorzugsweise über die Isolierung (5) hinweg, bevorzugt kontinuierlich, abnimmt.

5. Aktor nach einem der vorangehenden Ansprüche, wobei die Isolierung (5) aus einem elektromechanischen, vorzugsweise piezoelektrischen, besonders bevorzugt piezokeramischen, Material besteht.

6. Aktor nach einem der vorangehenden Ansprüche, wobei die Isolierung (5) undurchlässig/impermeabel für Wasserdampf/Feuchtigkeit ist.

7. Aktor nach einem der vorangehenden Ansprüche, wobei die Isolierung (5) mindestens aus einer Schicht, vorzugsweise aus zwei oder drei Schichten besteht, wobei die Gesamtdicke der Isolierung (5) 500 µm oder weniger, vorzugsweise 100 µm oder weniger, besonders bevorzugt 60 µm oder weniger, beträgt.

8. Aktor nach einem der vorangehenden Ansprüche, wobei zwei Außenelektroden (3) zur Kontaktierung der Elektroden (2) in der Stapelanordnung (1) vorgesehen sind, die an der gleichen Außenfläche oder an zwei unterschiedlichen Außenflächen des Aktors angeordnet sind, wobei mindestens eine elektrodenfreie Außenfläche des Aktors die keramische Isolierung (5) aufweist.

9. Verfahren zur Herstellung eines elektromechanischen Aktors, vorzugsweise des Aktors nach einem der vorangehenden Ansprüche, umfassend die Schritte:
A: Bilden einer Stapelanordnung (1) aus Elektroden (2) und aus keramischem Basismaterial mit elektromechanischen Eigenschaften entlang einer Stapelachse, sodass die Stapelanordnung zwei senkrecht zur Stapelachse ausgerichtete Stirnseiten und mindestens eine sich zwischen den Stirnseiten erstreckende Seitenfläche aufweist,
B: Versehen der Stapelanordnung (1) mit einer keramischen Isolierung (5), sodass diese sich auf der mindestens einen Seitenfläche von einer Stirnfläche zur anderen Stirnfläche erstreckt, das Gefüge der Isolierung (5) eine geringere mittlere Korngröße aufweist als das Gefüge des keramischen Basismaterials und die Isolierung (5) eine andere Materialzusammensetzung aufweist als das keramische Basismaterial.

10. Verfahren nach Anspruch 9, umfassend wenigstens einen der folgenden Teilschritte:
A1: Bilden der Stapelanordnung (1) aus den Elektroden (2) und aus Grünfolien aus dem keramischen Basismaterial,
A2: Sintern der Stapelanordnung (1), sodass das keramische Basismaterial in ein festes keramisches Gefüge überführt wird.

11. Verfahren nach Anspruch 9 oder 10, umfassend wenigstens einen der folgenden Teilschritte:
B1: Aufbringen wenigstens einer, mehrerer oder aller Schichten der keramischen Isolierung (5) auf die Stapelanordnung (1) durch Beschichten, vorzugsweise mit einer Grünfolie, Spritzgießen, Plasmaspritzen, Tauchumhüllung, vorzugsweise in keramischem Schlicker, Besprühen und/oder im Sol-Gel-Verfahren,
B2: Sintern der keramischen Isolierung (5) und gegebenenfalls des keramischen Basismaterials, sodass die keramische Isolierung (5) und gegebenenfalls das keramische Basismaterial in ein festes keramisches Gefüge überführt wird/werden,
B3: Einstellen der mittleren Korngröße der Isolierung (5) und gegebenenfalls der mittleren Korngröße des keramischen Basismaterials durch unterschiedliche Materialwahl für das keramische Basismaterial und die keramische Isolierung (5) und/oder durch Wahl der Prozessparameter während des Sintems.

12. Verfahren nach einem der Ansprüche 9 bis 11, umfassend den Schritt:
C: Polarisieren des keramischen Basismaterials, und vorzugsweise der keramischen Isolierung (5), zur Einstellung der elektromechanischen Eigenschaften des Aktors.

## Claims

1. Electromechanical actuator comprising a stack arrangement (1) made of ceramic basis material having electromechanical properties and electrodes (2) that are arranged along a stack axis, as well as a ceramic insulation (5) for use of said actuator in a humid environment, said stack arrangement (1) comprises two end faces aligned perpendicular to said stack axis and at least one side surface extending between said end faces, where said ceramic insulation (5) on said at least one side surface extends from one end face to the other end face, wherein the structure of said ceramic insulation (5) has a smaller average grain size than the structure of said ceramic basis material and wherein said insulation (5) has a different material composition than said ceramic basis material.

2. Actuator according to claim 1, wherein the ratio of the average grain sizes of insulation (5) to ceramic basis material is 3/4 or less, preferably 1/2 or less, particularly preferably 1/3 or less.

3. Actuator according to one of the preceding claims, wherein the average grain size of said insulation is 20 µm or less, preferably 5 µm or less, particularly preferably 1 µm or less.

4. Actuator according to one of the preceding claims, wherein the average grain size of the ceramic basis material decreases preferably continuously towards said insulation (5), preferably beyond said insulation (5).

5. Actuator according to one of the preceding claims, wherein said insulation (5) is made of electromechanical, preferably piezoelectric, particularly preferably piezoceramic, material.

6. Actuator according to one of the preceding claims, wherein said insulation (5) is impermeable to water vapor/moisture.

7. Actuator according to one of the preceding claims, wherein said insulation (5) is made of at least one layer, preferably of two or three layers, where the total thickness of said insulation (5) is 500 µm or less, preferably 100 µm or less, particularly preferably 60 µm or less.

8. Actuator according to one of the preceding claims, wherein two exterior electrodes (3) are provided for contacting said electrodes (2) in said stack arrangement (1) and are arranged on the same outer surface or on two different outer surfaces of said actuator, where at least one electrode-free outer surface of said actuator comprises said ceramic insulation (5).

9. Method for the production of an electromechanical actuator, preferably said actuator according to one of the preceding claims, comprising the steps of:
A: forming a stack arrangement (1) from electrodes (2) and from a ceramic basis material having electromechanical properties along a stack axis so that said stack arrangement comprises two end faces oriented perpendicular to said stack axis and at least one side surface extending between said end faces,
B: providing said stack arrangement (1) with a ceramic insulation (5) such that the latter extends on said at least one side surface from one end face to the other end face, the structure of said insulation (5) has a smaller average grain size than the structure of said ceramic basis material and said insulation (5) has a different material composition than said ceramic basis material.

10. Method according to claim 9 comprising at least one of the following partial steps of:
A1: forming said stack arrangement (1) from said electrodes (2) and from green tapes made of said ceramic basis material,
A2: sintering said stack arrangement (1) so that said ceramic basis material is transformed into a solid ceramic structure.

11. Method according to claim 9 or 10 comprising at least one of the following partial steps of:
B1: applying at least one, several, or all layers of said insulation (5) onto said stack arrangement (1) by coating, preferably with a green tape, injection molding, plasma spraying, immersion coating, preferably in ceramic slurry, spraying, and/or by way of a sol-gel method,
B2: sintering said ceramic insulation (5) and possibly said ceramic basis material so that said ceramic insulation (5) and possibly said ceramic basis material is/are transformed into a solid ceramic structure,
B3: setting the average grain size of said insulation (5) and possibly the average grain size of said ceramic basis material by selecting different materials for said ceramic basis material and said ceramic insulation (5) and/or by selecting the process parameters during sintering.

12. Method according to one of the claims 9 to 11 comprising the step of:
C: polarizing said ceramic basis material and preferably said ceramic insulation (5) to set the electromechanical properties of said actuator.

## Revendications

1. Actionneur électromécanique comprenant un empilement (1) de matériau de base céramique possédant des propriétés électromécaniques, ainsi que des électrodes (2) agencées le long d'un axe d'empilement et une isolation céramique (5) pour une utilisation de l'actionneur dans un environnement humide, dans lequel l'empilement (1) comporte deux faces d'extrémité orientées perpendiculairement à l'axe d'empilement et au moins une face latérale s'étendant entre les faces d'extrémité, dans lequel l'isolation céramique (5) s'étend sur au moins une face latérale d'une face d'extrémité à l'autre, dans lequel la structure de l'isolation céramique (5) présente une granulométrie moyenne plus fine que la structure du matériau de base céramique, et dans lequel l'isolation (5) présente une composition matérielle différente de celle du matériau de base céramique.

2. Actionneur selon la revendication 1, dans lequel le rapport de la granulométrie moyenne de l'isolation (5) par la granulométrie du matériau de base céramique est inférieure ou égale à 3/4, de préférence inférieure ou égale à 1/2, et de préférence encore inférieure ou égale à 1/3.

3. Actionneur selon l'une des revendications précédentes, dans lequel la granulométrie moyenne de l'isolant est inférieure ou égale à 20 µm, de préférence inférieure ou égale à 5 µm, et de préférence encore inférieure ou égale à 1 µm.

4. Actionneur selon l'une des revendications précédentes, dans lequel la granulométrie moyenne du matériau de base céramique diminue en direction de l'isolation (5), de préférence à travers l'isolation (5), et de préférence de manière continue.

5. Actionneur selon l'une des revendications précédentes, dans lequel l'isolation (5) est constituée d'un matériau électromécanique, de préférence d'un matériau piézoélectrique, et de préférence encore d'un matériau piézocéramique.

6. Actionneur selon l'une des revendications précédentes, dans lequel l'isolation (5) est étanche ou imperméable à la vapeur d'eau / à l'humidité.

7. Actionneur selon l'une des revendications précédentes, dans lequel l'isolation (5) est constituée d'au moins une couche, et de préférence de deux ou trois couches, dans lequel l'épaisseur totale de l'isolation (5) est inférieure ou égale à 500 µm, de préférence inférieure ou égale à 100 µm, et de préférence encore inférieure ou égale à 60 µm.

8. Actionneur selon l'une des revendications précédentes, dans lequel deux électrodes externes (3) sont pourvues pour entrer en contact avec les électrodes (2) dans l'empilement (1), qui sont agencées sur la même face externe ou sur deux faces externes différentes de l'actionneur, dans lequel au moins une face externe sans électrode de l'actionneur comporte l'isolation céramique (5).

9. Procédé de fabrication d'un actionneur électromécanique, de préférence de l'actionneur selon l'une des revendications précédentes, comprenant les étapes suivantes :
A : formation d'un empilement (1) d'électrodes (2) et d'un matériau de base céramique aux propriétés électromécaniques le long d'un axe d'empilement, de sorte que l'empilement présente deux faces d'extrémité orientées perpendiculairement à l'axe d'empilement et au moins une face latérale s'étendant entre les faces d'extrémité,
B : fourniture d'une isolation céramique (5) sur l'empilement (1) de sorte qu'elle s'étende sur au moins une face latérale d'une face d'extrémité à l'autre, que la structure de l'isolation (5) présente une granulométrie moyenne plus fine que celle de la structure du matériau de base céramique, et que l'isolation (5) présente une composition matérielle différente de celle du matériau de base céramique.

10. Procédé selon la revendication 9, comprenant au moins l'une des étapes suivantes :
A1 : formation de l'empilement (1) à partir des électrodes (2) et de feuilles vertes constituées du matériau de base céramique,
A2 : frittage de l'empilement (1) de sorte que le matériau de base céramique soit transformé en une structure céramique solide.

11. Procédé selon la revendication 9 ou 10, comprenant au moins l'une des étapes suivantes :
B1 : application d'au moins une, plusieurs ou toutes les couches d'isolation céramique (5) sur l'empilement (1) par revêtement, de préférence avec une feuille verte, via moulage par injection, via projection au plasma, via revêtement par trempage, de préférence dans une suspension céramique, via pulvérisation et/ou via un procédé sol-gel,
B2 : frittage de l'isolant céramique (5) et éventuellement du matériau de base céramique, de sorte que l'isolant céramique (5) et éventuellement le matériau de base céramique soient transformés en une structure céramique solide,
B3 : ajustement de la granulométrie moyenne de l'isolant (5) et, si nécessaire, de la granulométrie moyenne du matériau de base céramique en sélectionnant des matériaux différents pour le matériau de base céramique et l'isolant céramique (5) et/ou en réglant les paramètres du processus de frittage.

12. Procédé selon l'une quelconque des revendications 9 à 11, comprenant l'étape suivante :
C : polarisation du matériau de base céramique, et de préférence de l'isolation céramique (5), pour ajuster les propriétés électromécaniques de l'actionneur.
